# EUROPEAN PATENT APPLICATION

(11) **EP 4 739 010 A1**
(43) Date of publication of application: **06.05.2026**
(21) Application number: 24843312.0
(22) Date of filing: 10.06.2024
(51) Int. Cl.: H05K 5/04, H04M 1/02

(54) **ELECTRONIC DEVICE COMPRISING METAL HOUSING, AND METHOD FOR MANUFACTURING SAME**

(30) Priority: 17.07.2023 KR 20230092669; 26.07.2023 KR 20230097772
(71) Applicant: Samsung Electronics Co., Ltd., Suwon-si, Gyeonggi-do 16677 (KR)
(72) Inventor: LEE, Jonghun, Suwon-si Gyeonggi-do 16677 (KR); SON, Yunho, Suwon-si Gyeonggi-do 16677 (KR); CHOI, Hyunsuk, Suwon-si Gyeonggi-do 16677 (KR)
(74) Representative: Walaski, Jan Filip
(86) International application number: PCT/KR2024/007896
(87) International publication number: WO 2025/018591

(57) **Abstract**

An electronic device according to one embodiment of the present disclosure may comprise: a display; and a housing in which the display is seated. The housing may include a first metal part at least partially exposed to the outside of the electronic device, a second metal part surrounded by the first metal part, and a molded portion. The first metal part includes an opening formed to pass through a part of the first metal part, and the opening can be formed so that the space expands toward a first direction. The second metal part includes a coupling portion for coupling with the opening of the first metal part, and a melted portion may be formed in a portion of the coupling portion. The molded portion may cover the opening and at least a portion of the coupling portion.

## Description

### [Technical Field]

An embodiment set forth herein relates to an electronic device including a metal housing and a method for manufacturing the same.

### [Background Art]

With remarkable advancements in information and communication technology and semiconductor technology, the adoption and use of various electronic devices have been increasing rapidly. In particular, recent electronic devices are being developed to be portable and capable of communication.

An electronic device may refer to any device that performs specific functions according to programs installed therein, ranging from home appliances to electronic organizers, portable multimedia players, mobile communication terminals, tablet PCs, video/audio devices, desktop/laptop computers, and vehicle navigation systems. For example, such electronic devices can output stored information as audio or video. As the integration density of electronic devices has increased and ultra-high-speed, large-capacity wireless communication has become widespread, a wide variety of functions can now be incorporated into a single electronic device, such as a mobile communication terminal. For example, a communication function, an entertainment function such as gaming, a multimedia function such as music/video playback, a communication and security function for mobile banking, a function for schedule management or electronic wallet are integrated into a single electronic device. These electronic devices are being miniaturized to allow users to carry the electronic devices conveniently.

In recent electronic devices, the exterior housings are made of metal to meet consumers' demands for aesthetic appeal.

### [Detailed Description of the Invention]

### [Technical Solution]

An electronic device according to an embodiment of the disclosure may include a display and a housing in which the display is seated. The housing may include a first metal part at least partially exposed outside the electronic device, a second metal part surrounded by the first metal part, and a molded portion. The first metal part may include an opening formed through a portion of the first metal part, and the opening may be formed to have a space expanding in a first direction. The second metal part may include a coupling portion for coupling with the opening of the first metal part, and a portion of the coupling portion may form a melted portion. The molded portion may cover the opening and at least a portion of the coupling portion.

A housing of an electronic device according to an embodiment of the disclosure may include a first metal part at least partially exposed outside the electronic device, and a second metal part surrounded by the first metal part. The first metal part may include an opening formed through a portion of the first metal part and formed to have a space expanding in a first direction. The second metal part may include a coupling portion for coupling with the opening of the first metal part, and a portion of the coupling portion may form a melted portion.

A method for manufacturing a housing of an electronic device, according to an embodiment of the disclosure, may include a process of processing a first metal base material that includes an opening formed to have a space expanding in a first direction, a process of processing a second metal base material including a coupling portion that is coupled to the opening of the first metal base material, an alignment process for coupling the first metal base material and the second metal base material, wherein a support portion of the coupling portion is disposed in contact with an edge of the opening of the first metal base material, and a protruding portion extending from the support portion is disposed to be inserted into the opening of the first metal base material, a bonding process of applying heat to a surface of the support portion of the second metal base material which has been aligned with the first metal based material, the surface facing a second facing a second direction opposite to the first direction, and an injection-molding process of forming a molded base material portion in an area adjacent to the first metal base material and the second metal base material.

### [Brief Description of Drawings]

FIG. 1 is a block diagram illustrating an electronic device 101 in a network environment 100 according to various embodiments.
FIG. 2 is a perspective view illustrating the front surface of an electronic device according to an embodiment disclosed herein.
FIG. 3 is a perspective view illustrating the rear surface of the electronic device illustrated in FIG. 2 according to an embodiment disclosed herein.
FIG. 4A is an exploded perspective view of the electronic device illustrated in FIG. 2 according to an embodiment disclosed herein, and illustrates the front surface thereof.
FIG. 4B is an exploded perspective view of the electronic device illustrated in FIG. 2 according to an embodiment disclosed herein, and illustrates the rear surface thereof.
FIG. 5 is a perspective view illustrating a portion of a housing of an electronic device according to an embodiment of the disclosure, with the electrical components excluded.
FIG. 6 is an enlarged cross-sectional view illustrating a portion of a coupling portion of the housing, taken along line A-A' in FIG. 5, according to an embodiment of the disclosure.
FIG. 7 is a flowchart for forming a coupling structure of a housing of an electronic device according to an embodiment of the disclosure.
FIG. 8A illustrates the coupling state between a first metal base material and a second metal base material during the process of forming a housing of an electronic device according to an embodiment of the disclosure.
FIG. 8B illustrates the coupling state among a first metal part, a second metal part, and a molded portion of a housing of an electronic device according to an embodiment of the disclosure.
FIG. 9 sequentially illustrates a coupling process among a first metal base material, a second metal base material, and a molded base material of a housing of an electronic device according to an embodiment of the disclosure.
FIG. 10 sequentially illustrates a coupling process among a first metal base material, a second metal base material, and a molded base material of a housing of an electronic device according to an embodiment of the disclosure.
FIG. 11 sequentially illustrates a coupling process among a first metal base material, a second metal base material, and a molded base material of a housing of an electronic device according to an embodiment of the disclosure.
FIG. 12A illustrates the coupling relationship between a first metal part and a second metal part of a housing of an electronic device according to an embodiment of the disclosure.
FIG. 12B illustrates the assembled state between a first metal base material and a second metal base material before a bonding process in a housing forming process for an electronic device according to an embodiment of the disclosure.
FIG. 12C illustrates the coupled state between a first metal base material and a second metal base material after a bonding process in a housing formation process for an electronic device according to an embodiment of the disclosure.

### [Mode for Carrying out the Invention]

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

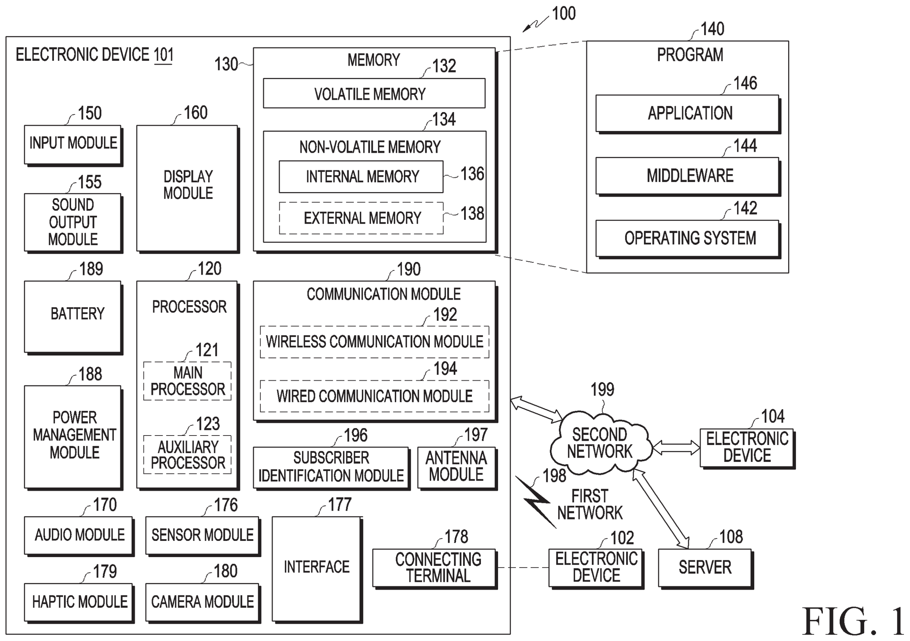

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

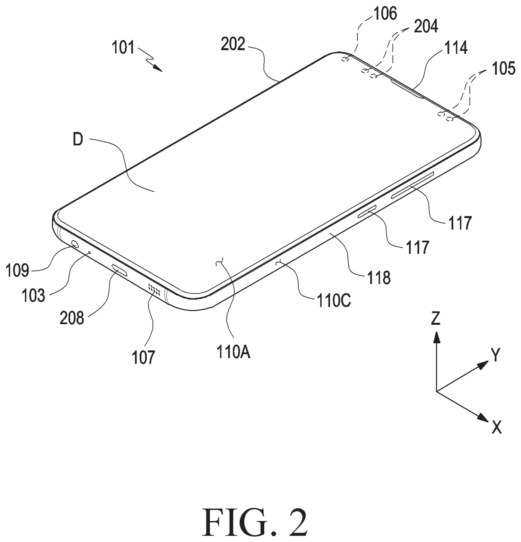

FIG. 2 is a perspective view illustrating the front surface of an electronic device according to an embodiment disclosed herein.

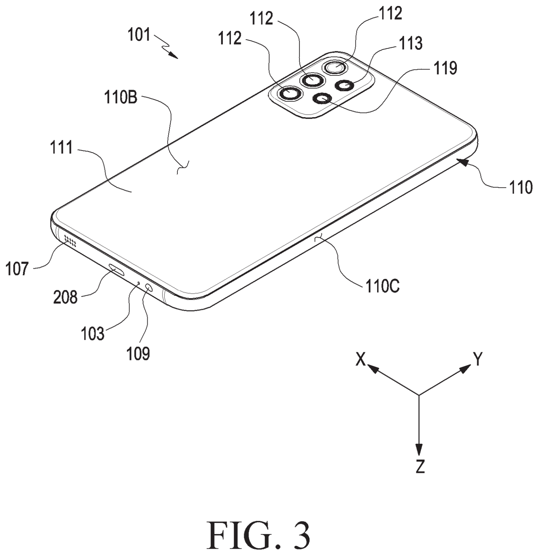

FIG. 3 is a perspective view illustrating the rear surface of the electronic device illustrated in FIG. 2 according to an embodiment disclosed herein.

Referring to FIGS. 2 and 3, an electronic device 101 (e.g., the electronic device 101 in FIG. 1) according to an embodiment may include a housing 110 including a first surface (or front surface) 110A, a second surface (or rear surface) 110B, and a side surface 110C that surrounds the space between the first surface 110A and the second surface 110B. In an embodiment (not shown), the housing 110 may also refer to a structure forming some among the first surface 110A in FIG. 2, the second surface 110B in FIG. 3, and the side surface 110C in FIG. 3.

According to an embodiment, the first surface 110A may be formed at least in part by a substantially transparent front plate 102 (e.g., a glass plate or polymer plate containing various coating layers). The second surface 110B may be formed by a substantially opaque rear plate 111. The rear plate 111 may be formed, for example, by coated or colored glass, ceramic, polymer, metal (e.g., aluminum, stainless steel (STS), or magnesium), or a combination of at least two of these materials. The side surface 110C may be formed by a side structure (or "side bezel structure") 118 that is coupled to the front plate 102 and rear plate 111 and includes metal and/or polymer. In an embodiment, the rear plate 111 and the side structure 118 may be formed integrally and may include the same material (e.g., a metallic material such as aluminum).

According to an embodiment, the front plate 102 may include an area (areas) that are curved and seamlessly extend toward the rear plate 111 at least at a portion of the edge thereof. For example, the front plate 102 (or the rear plate 111) may include only one of the areas curved and extending toward the rear plate 111 (or the front plate 102) in one edge of the first surface 110A. According to an embodiment, the front plate 102 or the rear plate 111 may have a substantially flat plate shape, and in this case, may not include an area that is curved and extends. When the front plate 102 or the rear plate 111 includes an area that is curved and extends, the thickness of the electronic device 101 at the portion including the curved and extending area may be smaller than the thickness of other portions.

According to an embodiment, the electronic device 101 may include at least one among a display 101, audio modules (e.g., a microphone hole 103, an external speaker hole 107, and a call receiver hole 114), sensor modules (e.g., a first sensor module 104, a second sensor module (not shown), and a third sensor module 119), camera modules (e.g., a first camera device 105, a second camera device 112, and a flash 113), key input devices 117, a light-emitting element 106, and connector holes (e.g., a first connector hole 108, a second connector hole 109). In an embodiment, the electronic device 101 may omit at least one (e.g., the key input devices 117 or the light-emitting element 106) of the components or additionally include other components.

The display 101 may output a screen or be visually exposed through a substantial portion of the first surface 110A (e.g., the front plate 102). In an embodiment, at least a portion of the display 101 may be visually exposed through the front plate 102 forming the first surface 110A or through a portion of the side surface 110C. In an embodiment, the edges of the display 101 may be formed substantially identical to the adjacent outer contour of the front plate 102. In an embodiment (not shown), to increase the visually exposed area of the display 101, the gap between the outer edge of the display 101 and the outer edge of the front plate 102 may be formed to be substantially uniform.

According to an embodiment, a recess or an opening may be formed in a portion of the screen display area of the display 101, and the display 101 may include at least one among an audio module (e.g., the call receiver hole 114), a sensor module (e.g., the first sensor module 104), a camera module (e.g., the first camera device 105), and the light-emitting element 106, which are aligned with the recess and the opening. In an embodiment (not shown), the rear surface of the screen display area of the display 101 may include at least one among an audio module (e.g., the call receiver hole 114), the sensor module (e.g., the first sensor module 104), a camera module (e.g., the first camera device 105), a fingerprint sensor (not shown), and the light-emitting element 106. In an embodiment (not shown), the display 101 may be coupled to or disposed adjacent to a touch sensing circuit, a pressure sensor capable of measuring touch intensity (pressure), and/or a digitizer that detects a magnetic field-type stylus pen.

According to an embodiment, the audio modules 103, 107, and 114 may include a microphone hole 103 and speaker holes (e.g., the external speaker hole 107 and the call receiver hole 114). The microphone hole 103 may have a microphone disposed therein to acquire external sounds, and in an embodiment, multiple microphones may be disposed to detect the direction of sound. The speaker holes may include the external speaker hole 107 and the call receiver hole 114. In an embodiment, the speaker holes (e.g., the external speaker hole 107 and the call receiver hole 114) and the microphone hole 103 may be implemented as a single hole, or a speaker may be included without speaker holes (e.g., the external speaker hole 107 and the call receiver hole 114) (e.g., piezo speaker).

According to an embodiment, the sensor modules may generate electrical signals or data value corresponding to the operating state inside the electronic device 101 or the external environmental state. The sensor modules may include, for example, the first sensor module 104 (e.g., a proximity sensor) and/or the second sensor module (not shown) (e.g., a fingerprint sensor) disposed on the first surface 110A of the housing 110, and/or the third sensor module 119 disposed on the second surface 110B of the housing 110. The second sensor module (not shown) (e.g., the fingerprint sensor) may be disposed not only on the first surface 110A of the housing 110 (e.g., the display 101), but also on the second surface 110B or the side surface 110C. The electronic device 101 may further include at least one of, for example, a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an ambient light sensor 104.

According to an embodiment, the camera modules may include the first camera device 105 disposed on the first surface 110A of the electronic device 101, the second camera device 112 disposed on the second surface 110B, and/or the flash 113. The camera devices (e.g., the first camera device 105 and the second camera device 112) may each include one or more lenses, an image sensor, and/or an image signal processor. The flash 113 may include, for example, a light-emitting diode or a xenon lamp. In an embodiment, one or more lenses (infrared camera, wide-angle and telephoto lenses) and image sensors may be disposed on one surface of the electronic device 101. In an embodiment, the flash 113 may emit infrared light, and infrared light emitted by the flash 113 and reflected by a subject may be received via the third sensor module 119. The electronic device 101 or a processor (e.g., the processor 120 in FIG. 1) of the electronic device 101 may detect depth information of the subject, based on the timing at which infrared light is received by the third sensor module 119.

According to an embodiment, the key input devices 117 may be disposed on the side surface 110C of the housing 110. In an embodiment, the electronic device 101 may not include some or all of the above-described key input devices 117, and any omitted key input device 117 may be implemented in another form, such as a soft key, on the display 101. In an embodiment, the key input devices may include a sensor module disposed on the second surface 110B of the housing 110.

According to an embodiment, the light-emitting element 106 may be disposed, for example, on the first surface 110A of the housing 110. The light-emitting element 106 may, for example, provide state information of the electronic device 101 in the form of light. In an embodiment, the light-emitting element 106 may, for example, provide a light source that operates in conjunction with the operation of a camera module (e.g., the first camera device 105). The light-emitting element 106 may include, for example, an LED, an IR LED, and a xenon lamp.

According to an embodiment, the connector holes (e.g., the first connector hole 108 and the second connector hole 109) may include the first connector hole 108 capable of accommodating a connector (e.g., a USB connector) for transmitting and receiving power and/or data to and from an external electronic device (e.g., the electronic device 1002 in FIG. 1), and/or the second connector hole (e.g., an earphone jack) 109 capable of accommodating a connector for transmitting and receiving audio signals to and from the external electronic device.

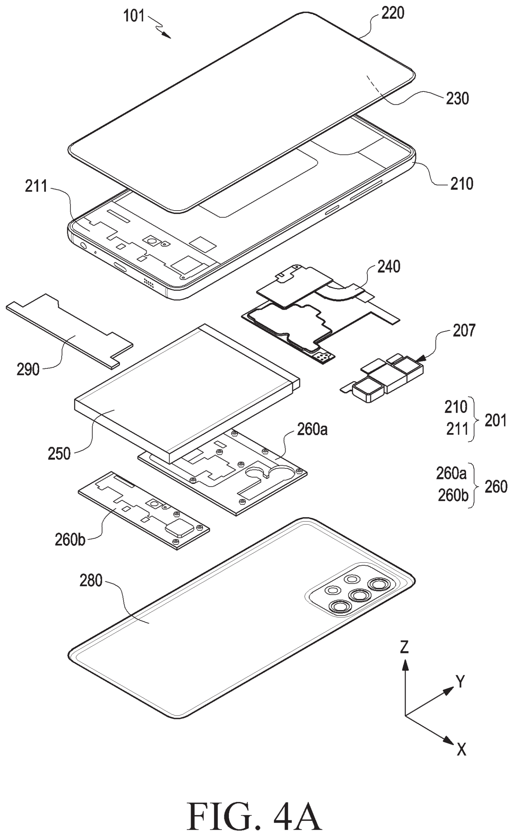

FIG. 4A is an exploded perspective view of the electronic device illustrated in FIG. 2 according to an embodiment disclosed herein, and illustrates the front surface thereof.

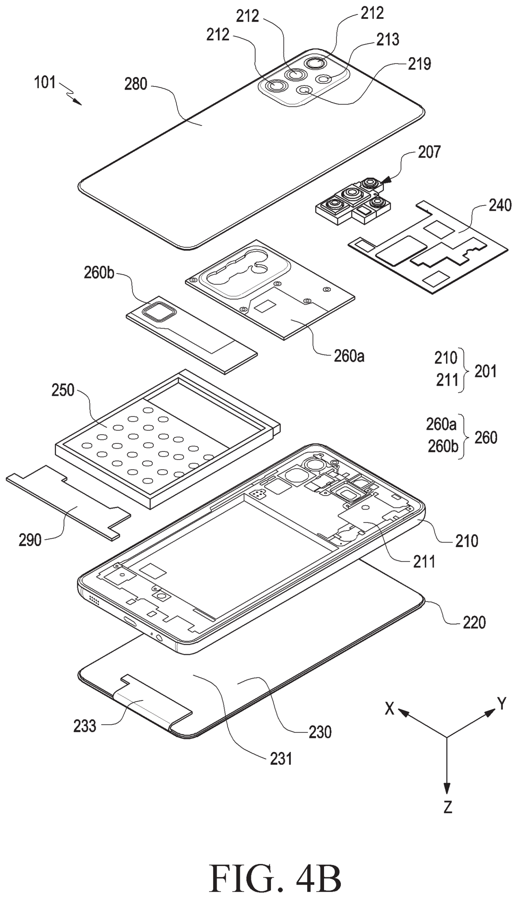

FIG. 4B is an exploded perspective view of the electronic device illustrated in FIG. 2 according to an embodiment disclosed herein, and illustrates the rear surface thereof.

Referring to FIGS. 4A and 4B, an electronic device 101 (e.g., the electronic device 101 in FIG. 1, FIG. 2, or FIG. 3) may include a side structure 210, a first support member 211 (e.g., a bracket), a front plate 220 (e.g., the front plate 102 in FIG. 2), a display 230 (e.g., the display 101 in FIGS. 2 and 3), a printed circuit board (or a board assembly) 240, a battery 250, a second support member 260 (e.g., a rear case), an antenna, a camera assembly 207, and a rear plate 280 (e.g., the rear plate 111 in FIG. 3).

According to an embodiment, the electronic device 101 may omit at least one (e.g., the first support member 211 or the second support member 260) of the components or additionally include other components. At least one component of the components of the electronic device 101 may be identical or similar to at least one of the components of the electronic device 101 illustrated in FIG. 2 or FIG. 3, and redundant descriptions are omitted hereinafter.

According to an embodiment, the first support member 211 may be disposed inside the electronic device 101 and connectable to the side structure 210, or may be integrally formed with the side structure 210. The first support member 211 may be formed, for example, of a metallic material and/or a non-metallic material (e.g., polymer). When at least partially formed of a metallic material, a portion of the side structure 210 or the first support member 211 may function as an antenna. The first support member 211 may have one surface to which the display 230 is coupled, and the other surface to which the printed circuit board 240 is coupled. The printed circuit board 240 may be equipped with a processor (e.g., the processor 120 in FIG. 1), memory (e.g., the memory 130 in FIG. 1), and/or an interface (e.g., the interface 177 in FIG. 1). The processor may include, for example, one or more of a central processing unit, an application processor, a graphics processing unit, an image signal processor, a sensor hub processor, or a communication processor.

According to an embodiment, the first support member 211 and the side structure 210 may be combined and referred to as a front case or a housing 201. According to an embodiment, the housing 201 may generally be understood as a structure for accommodating, protecting, or arranging the printed circuit board 240 or the battery 250. In an embodiment, the housing 201 may be understood as including structures that are visually or tactilely perceptible to a user in the exterior of the electronic device 101, such as the side structure 210, the front plate 220, and/or the rear plate 280. In an embodiment, "the front or rear surface of the housing 201" may refer to the first surface 110A in FIG. 2 or the second surface 110B in FIG. 3. In an embodiment, the first support member 211 may be disposed between the front plate 220 (e.g., the first surface 110A in FIG. 2) and the rear plate 280 (e.g., the second surface 110B in FIG. 3) and may function as a structure for mounting electrical/electronic components such as the printed circuit board 240 or the camera assembly 207.

According to an embodiment, the display 230 may include a display panel 231 and a flexible printed circuit board 233 extending from the display panel 231. The flexible printed circuit board 233 may be understood to be, for example, at least partially disposed on the rear surface of the display panel 231 while being electrically connected to the display panel 231. In an embodiment, reference numeral "231" may be understood to be a protective sheet disposed on the rear surface of the display panel. For example, unless otherwise distinguished in the subsequent detailed description, the protective sheet may be understood as a part of the display panel 231. In an embodiment, the protective sheet may function as a cushioning structure for absorbing external forces (e.g., a low-density elastic material such as sponge) or an electromagnetic shielding structure (e.g., a copper sheet (CU sheet)). According to an embodiment, the display 230 may be disposed on the inner surface of the front plate 220 and may output a screen through at least a portion of the first surface 110A in FIG. 2 or the front plate 220 by including a light-emitting layer. As mentioned above, the display 230 may substantially output a screen over the entire area of the first surface 110A in FIG. 2 or the front plate 220.

According to an embodiment, the memory may include, for example, volatile memory or non-volatile memory.

According to an embodiment, the interface may include, for example, a high-definition multimedia interface (HDMI), a universal serial bus (USB) interface, an SD card interface, and/or an audio interface. The interface may, for example, electrically or physically connect the electronic device 101 to an external electronic device and may include a USB connector, an SD card/MMC connector, or an audio connector.

According to an embodiment, the second support member 260 may include, for example, an upper support member 260a and a lower support member 260b. In an embodiment, the upper support member 260a may be disposed to surround the printed circuit board 240 together with a portion of the first support member 211. A circuit device (e.g., a processor, a communication module, or memory) implemented as an integrated circuit chip, or various electrical/electronic components may be arranged on the printed circuit board 240. According to an embodiment, the printed circuit board 240 may receive an electromagnetic shielding environment from the upper support member 260a. In an embodiment, the lower support member 260b may be utilized as a structure for arranging electrical/electronic components such as a speaker module, an interface (e.g., a USB connector, an SD card/MMC connector, or an audio connector). In an embodiment, electrical/electronic components such as a speaker module, an interface (e.g., a USB connector, an SD card/MMC connector, or an audio connector) may be arranged on an additional printed circuit board that is not illustrated. In this case, the lower support member 260b may be disposed to surround the additional printed circuit board together with another portion of the first support member 211. The speaker module or the interface arranged on the additional printed circuit board, which is not illustrated, or the lower support member 260b may be arranged to correspond to the audio modules (e.g., the microphone hole 103 or the speaker holes (e.g., the external speaker hole 107 and the call receiver hole 114) or the connector holes (e.g., the first connector hole 108 and the second connector hole 109) in FIG. 2.

According to an embodiment, the speaker module or the interface may be arranged corresponding to an audio module 207 or the connector hole 108 or 109.

According to an embodiment, the battery 250 may be a device for supplying power to at least one component of the electronic device 101, and may include, for example, a non-rechargeable primary battery, a rechargeable secondary battery, or a fuel cell. At least a portion of the battery 250 may be substantially coplanar with, for example, the printed circuit board 240. The battery 250 may be integrally disposed in the electronic device 101 or may be detachably disposed in the electronic device 101.

According to an embodiment, the electronic device 101 may further include a separate sub-circuit board 290 disposed in the first support member 211 and spaced apart from the printed circuit board 240. The sub-circuit board 290 may be electrically connected to the printed circuit board 240 via a connection member such as a flexible connection substrate or a cable. The sub-circuit board 290 may be electrically connected to the battery 289 or electrical components disposed in the end area of the electronic device 101, such as a speaker, a USB connector, an antenna connector, and/or a SIM socket, to transmit signals and power.

Although not illustrated, the antenna may include a conductive pattern formed on the surface of the second support member 260, for example, via a laser direct structuring process. In an embodiment, the antenna may include a printed circuit pattern formed on the surface of a thin film, and the thin-film antenna may be disposed between the rear plate 280 and the battery 250. The antenna may include, for example, a near-field communication (NFC) antenna, a wireless charging antenna, and/or a magnetic secure transmission (MST) antenna. The antenna may, for example, perform near-field communication with an external device or wirelessly transmit and receive power required for charging to the external device. In an embodiment, other antenna structures may be formed by the side structure 210 and/or a portion of the first support member 211, or a combination thereof.

According to an embodiment, the camera assembly 207 may include at least one camera module. Inside the electronic device 101, the camera assembly 207 may receive at least a portion of light incident through an optical hole or camera windows 212, 213, and 219. In an embodiment, the camera assembly 207 may be disposed on a first support member 211 at a position adjacent to a printed circuit board 240. In an embodiment, the camera module(s) of the camera assembly 207 may be generally aligned with one of the camera windows 212, 213, and 219 and may be at least partially surrounded by the second support member 260 (e.g., the upper support member 260a).

Hereinafter, the coupling structure of the housing will be described in detail.

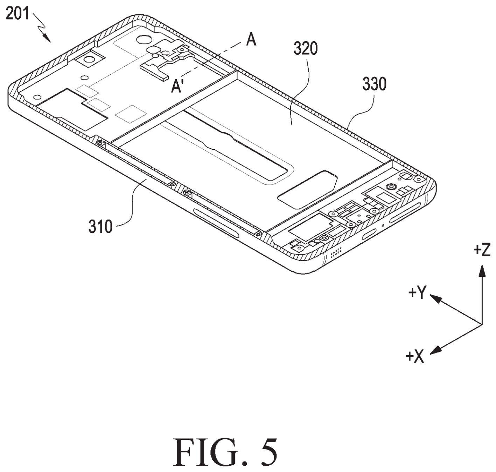

FIG. 5 is a perspective view illustrating a portion of a housing of an electronic device according to an embodiment of the disclosure, with the electrical components excluded.

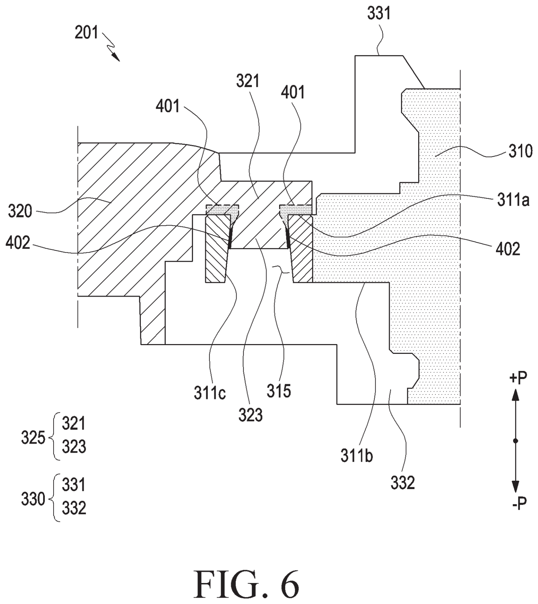

FIG. 6 is an enlarged cross-sectional view illustrating a portion of a coupling portion of the housing, taken along line A-A' in FIG. 5, according to an embodiment of the disclosure.

According to an embodiment, the electronic device 101 may include a housing 201 (e.g., the first support member 211 and the side structure 210 in FIGS. 4A and 4B). The housing 201 may include a first metal part 310 (e.g., an outer metal part), a second metal part 320 (e.g., an inner metal part), and a molded portion 330. According to an embodiment, the housing 201 may be understood as a structure for accommodating, protecting, or arranging a printed circuit board (e.g., the printed circuit board 240 in FIGS. 4A and 4B) or a battery (the battery 250 in FIGS. 4A and 4B).

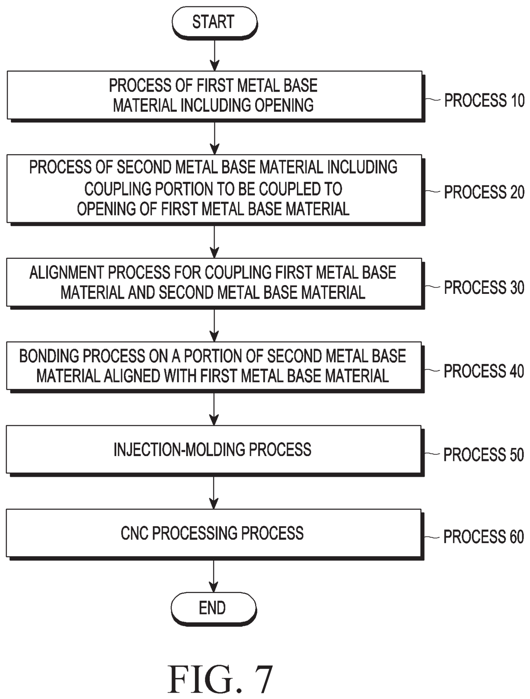

The configuration of the housing 201 in FIGS. 5 and 6 may be partially or entirely identical to the configuration of the housing 201 in FIGS. 4A and 4B. The embodiments in FIGS. 5 and 6 may be partially combined with the embodiments in FIGS. 1 to 4B, or with the embodiments in FIGS. 7 to 12C.

According to an embodiment, the housing 201 may include a first metal part 310 and a second metal part 320 surrounded by the first metal part 310. According to an embodiment, the housing 201 may include a first metal part 310, a second metal part 320 surrounded by the first metal part 310, and a molded portion 330.

According to an embodiment, the first metal part 310 of the housing 201 may form the exterior of the electronic device 101. The second metal part 320 of the housing 201 may support a display (e.g., the display 220 in FIGS. 4A and 4B) and provide space in which internal components are arranged. The molded portion 330 of the housing 201 may be disposed along the boundary surface between the first metal part 310 and the second metal part 320.

According to an embodiment, the first metal part 310 and the second metal part 320 may be formed of a single metal material. For example, the first metal part 310 forming the exterior and the second metal part 320 disposed inside the first metal part 310 may be formed of at least one material selected from steel use stainless (SUS), titanium (titan), magnesium, aluminum, ceramic, or glass.

According to an embodiment, the first metal part 310 and the second metal part 320 of the housing 201 may be formed of different metal materials (e.g., dissimilar metal materials). For example, the first metal part 310 forming the exterior may be formed of a material providing an aesthetically pleasing appearance, such as steel use stainless (SUS), titanium (titan), or magnesium. The second metal part 320 disposed inside the first metal part 310 may be formed of a material advantageous for processing, such as aluminum.

According to an embodiment, after the first metal part 310 and the second metal part 320 of the housing 201 are coupled, the molded portion 330 formed by an injection-molding process may be disposed on the coupled portion and at least part of the surfaces of the first metal part 310 and the second metal part 320. The molded portion 330 may cover the coupled portion to prevent corrosion and allow the overall shape of the housing 201 to be designed. Subsequently, the final shape of the housing 201 may be designed through a computer numerical control (CNC) process.

According to an embodiment, the housing 201 may be formed through a coupling structure between the first metal part 310 and the second metal part 320. The first metal part 310 is a portion at least partially exposed to the outside of the electronic device 101 and may include an opening 315 formed through one area thereof. The second metal part 320 may include a coupling portion 325 for coupling with the opening 315 of the first metal part 310. The overall shape of the first metal part 310, the opening 315 formed in a portion thereof, and/or the coupling portion 325 of the second metal part 320 may be formed through a computer numerical control (CNC) process.

According to an embodiment, the opening 315 of the first metal part 310 (e.g., the diameter of the opening 315) may have a shape in which at least a partial space expands in a -P direction. For example, the -P direction may be the upward direction (e.g., a display direction) or the downward direction (e.g., a rear plate direction) of the electronic device 101. For example, the -P direction may be the direction faced by a protruding portion 323 protruding from a support portion 321 of the second metal part 320. For example, the -P direction may be the direction opposite to one surface (e.g., one surface facing a +P direction) of the support portion 321 of the second metal part 320, on which a bonding process (e.g., a welding process, a laser process, or a heating process) is performed.

According to an embodiment, the opening 315 of the first metal part 310 may be formed through a portion of the first metal part 310. The opening 315 formed through a portion of the first metal part 310 may be formed such that the inner space varies along the +P direction or the -P direction. For example, the opening 315 of the first metal part 310 may be configured such that the inner space (e.g., the diameter of the opening 315) sequentially (or progressively) expand along the -P direction. For example, the opening 315 of the first metal part 310 may expand only within a portion of the inner space along the -P direction.

According to an embodiment, the cross-section of the opening 315 of the first metal part 310 may have a trapezoidal shape. For example, when viewed from above or below the opening 315 in the -P direction or +P direction, the opening 315 may be a circular, square, or polygonal shape. When the opening 315 is a circular opening, the diameter of the upper space of the opening 315 may be different from the diameter of the lower space of the opening 315 when the upper side or the lower side of the opening 315 is viewed from the -P direction or +P direction. For example, the diameter of the lower space of the opening 315 may be larger than the diameter of the upper space of the opening 315.

According to an embodiment, the opening 315 of the first metal part 310 may have an undercut shape. For example, an inner surface 311c of the first metal part 310 forming the opening 315 may form an inclined surface having a specified inclination with respect to an upper surface 311a (e.g., the surface facing +P) or a lower surface (e.g., the surface facing -P) of the first metal part 310 adjacent to the opening 315.

According to an embodiment, the height (e.g., the length in the -P direction or +P direction) of the opening 315 of the first metal part 310 may be greater than the height (e.g., the length in the -P direction or +P direction) of the protruding portion 323. For example, the protruding portion 323 of the second metal part 320, which is inserted into the opening 315 formed through one area of the first metal part 310, may be located within the opening 315 and may not be exposed outside the opening 315.

According to an embodiment, the housing 201 may be formed through a coupling structure between the first metal part 310 and the second metal part 320. The second metal part 320 may be formed such that at least a portion thereof is surrounded by the first metal part and may include the coupling portion 325 for coupling with the opening 315 of the first metal part 310. The coupling portion 325 of the second metal part 320 may include the support portion 321 adjacent to the edge of the opening 315 of the first metal part 310 and the protruding portion 323 protruding from the support portion 321.

According to an embodiment, the support portion 321 of the second metal part 320 may be disposed in contact with the first metal part 310 and may face the upper space of the opening 315 (e.g., the space facing the +P direction). The protruding portion 323 of the second metal part 320 may protrude from the support portion 321 in the -P direction and may be inserted into the opening 315 and coupled to a portion of the inner surface of the first metal part 310. The protruding portion 323 of the second metal part 320 may have a shape such as a pole, a protrusion, or a rib.

According to an embodiment, a plurality of coupling structures may be formed between the first metal part 310 and the second metal part 320. The coupling structures may be formed in various ways in the area where the first metal part 310 and the second metal part 320 come into contact with each other. According to an embodiment, the coupling structure (e.g., bonding structure) between the first metal part 310 and the second metal part 320 may include a first coupling portion formed by chemical coupling (e.g., melting) and a second coupling portion formed by physical coupling.

According to an embodiment, the coupling structure between the first metal part 310 and the second metal part 320 may be a structure in which the support portion 321 of the second metal part 320 is disposed in contact with the adjacent edge of the opening 315 of the first metal part 310, and the protruding portion 323 of the second metal part 320 is inserted into the opening 315 of the first metal part 310. Hereinafter, before the final product, such as the bonding process (e.g., the welding process, the laser process), the first metal part 310 may be referred to as the first metal base material, and the second metal part 320 may be referred to as the second metal base material. The coupling portion 325 (e.g., the support portion 321 and the protruding portion 323) of the first metal part 310 may be referred to in the same manner. The opening 315 of the second metal part 320 may be referred to in the same manner.

Before the bonding process (e.g., the welding process, the laser process, or the heating process), the protruding portion 323 of the second metal base may be smaller than the inner space of the opening 315 of the first metal part 310, and thus may not be in a fitted and coupled state. When heat is applied to the upper surface of the support portion 321 (e.g., one surface facing +P) (e.g., a welding process or laser process), the heat may be transferred to the support portion 321 and to the protruding portion 323 protruding from the lower surface of the support portion 321 (e.g., one surface facing -P). The protruding portion 323 melted by the transferred heat may deform into a shape corresponding to the shape (e.g., an undercut shape) of the opening 315. The protruding portion 323 corresponding to the opening 315 may have an undercut shape, and may be fitted in and coupled to the opening 315.

According to an embodiment, the coupling structure between the first metal part 310 and the second metal part 320 may be a structure in which the support portion 321 of the second metal part 320 is disposed in contact with the adjacent edge of the opening 315 of the first metal part 310, and the protruding portion 323 of the second metal part 320 is inserted into the opening of the first metal part 310. According to an embodiment, the support portion 321 of the second metal part 320 may be partially melted through a bonding process to form a chemical coupling portion (e.g., the first coupling portion) with the first metal part 310 which the support portion 321 contacts. The bonding process may be performed using physical force, such as agitation or welding, without applying heat, or may be performed using at least one of a laser process utilizing light or a heating process utilizing heat. According to an embodiment, the adjacent edge of the opening 315 of the first metal part 310 may be partially melted through the bonding process to form a chemical coupling portion (e.g., the first bonded portion) with the second metal part 320 which the edge of the first metal part 310 contacts. The support portion 321 of the second metal part 320 and/or an adjacent edge 401 of the opening 315 melted together with the support portion 321 may be referred to as a melted portion.

According to an embodiment, the melted portion 401 may include, in addition to the support portion 321, a portion of the protruding portion 323 adjacent to the support portion 321, and an inner portion of the opening 315 melted together with a portion of the protruding portion 323.

According to an embodiment, the protruding portion 323 of the second metal part 320 inserted into the opening 315 of the first metal part 310 forms a physical coupling portion (e.g., the second coupling portion) by being fitted in and coupled to the opening 315. For example, the protruding portion 323 of the second metal base material may be melted through a bonding process (e.g., a welding process, a laser process, or a heating process) to fill a portion of the opening 315. Subsequently, the cooled protruding portion 323 may be fitted in and coupled to the opening 315 of the first metal part 310. A portion of the protruding portion 323 and/or the opening 315 fitted onto and coupled to the protruding portion 323 (e.g., the inner surface of the first metal part 310 forming the opening 315) may be referred to as a non-melted portion 402. The protruding portion 323 of the second metal part 320 may be inserted into only a portion of the opening 315 of the first metal part 310.

According to an embodiment, the coupling structure (e.g., the bonding structure) between the first metal part 310 and the second metal part 320 may include a first coupling portion formed by chemical coupling (e.g., melting) and a second coupling portion formed by physical coupling. Within an expanded structure (e.g., an undercut structure) of the opening 315 of the first metal part 310, a melted bonded portion, in which a portion of the second metal base material is melted and filled through a bonding process, and a non-melted portion may be formed. The bonding structure between the first metal part 310 and the second metal part 320 that are melted and bonded to each other may increase the bonding strength due to chemical coupling. The increase in the area of the protruding portion 323 of the second metal part, which is not melted and fills the expanded structure shape of the opening 315, may increase the contact area with the first metal part 310, thereby forming a structure that resists external forces in three dimensions and increasing the bonding strength.

According to an embodiment, the molded portion 330 may be positioned on the upper and/or lower side of the coupling structure (e.g., the bonding structure) between the first metal part 310 and the second metal part 320. The molded portion 330 may be disposed to cover the coupling structure between the first metal part 310 and the second metal part 320, thereby limiting or reducing corrosion of the coupling structure.

According to an embodiment, the molded portion 330 may include a first molded portion 330 disposed on the upper side (e.g., the +P direction) of the coupling structure and a second molded portion 330 disposed on the lower side (e.g., the -P direction) of the coupling structure. The first molded portion 330 may be disposed to surround the upper surface (e.g., a surface facing the +P direction) of the support portion 321 of the second metal part 320 and the first metal part 310 in contact therewith. For example, the first molded portion 330 may be disposed to surround at least a portion of the melted portion (e.g., the support portion 321 of the second metal part 320 and/or the adjacent edge 401 of the opening 315 melted together with the support portion 321). The second molded portion 330 may be disposed to surround the outer surface (e.g., a surface facing the -P direction) of the protruding portion 323 of the second metal part 320 and the first metal part 310 in contact therewith. For example, the second molded portion 330 may be disposed within the opening 315 together with the protruding portion 323 of the second metal part 320. For example, the second molded portion 330 may be disposed to surround at least a portion of the non-melted portion 402 (e.g., a portion of the protruding portion 323 of the second metal part 320 and the inner surface of the first metal part 310 forming the opening 315).

FIG. 7 is a flowchart for forming a coupling structure of a housing of an electronic device according to an embodiment of the disclosure.

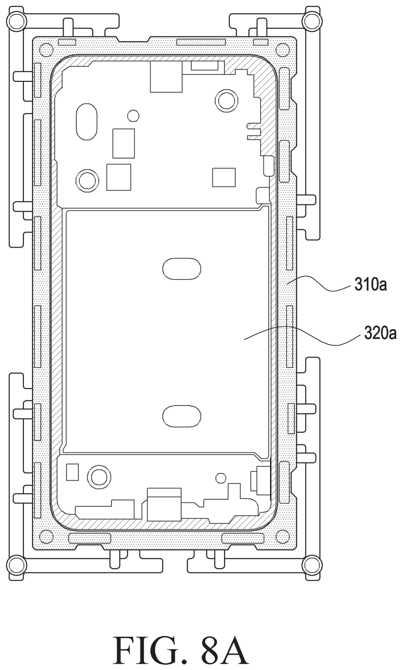

FIG. 8A illustrates the coupling state between a first metal base material and a second metal base material during the process of forming a housing of an electronic device according to an embodiment of the disclosure.

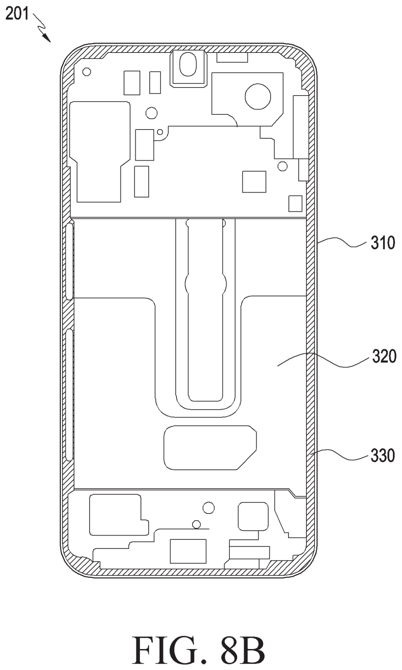

FIG. 8B illustrates the coupling state among a first metal part, a second metal part, and a molded portion of a housing of an electronic device according to an embodiment of the disclosure.

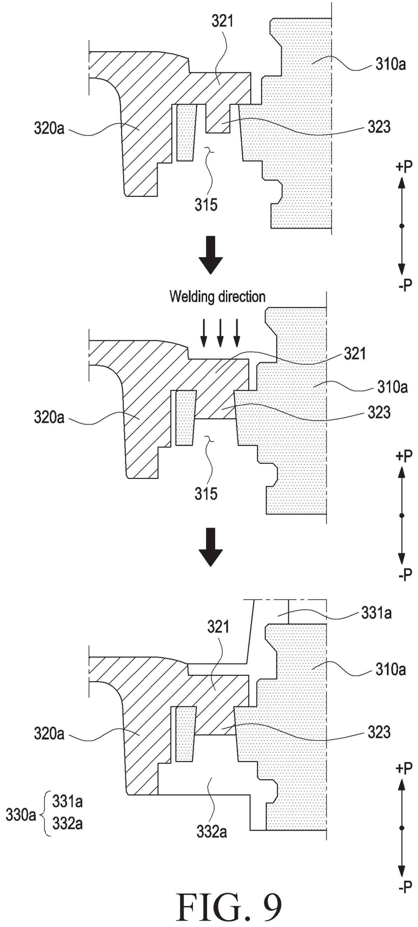

FIG. 9 sequentially illustrates a coupling process among a first metal base material, a second metal base material, and a molded base material of a housing of an electronic device according to an embodiment of the disclosure.

According to an embodiment, the electronic device 101 may include a housing 201 (e.g., the first support member 211 and side structure 210 in FIGS. 4A and 4B). The housing 201 may include a first metal part 310 (e.g., an outer metal part), a second metal part 320 (e.g., an inner metal part), and a molded portion 330.

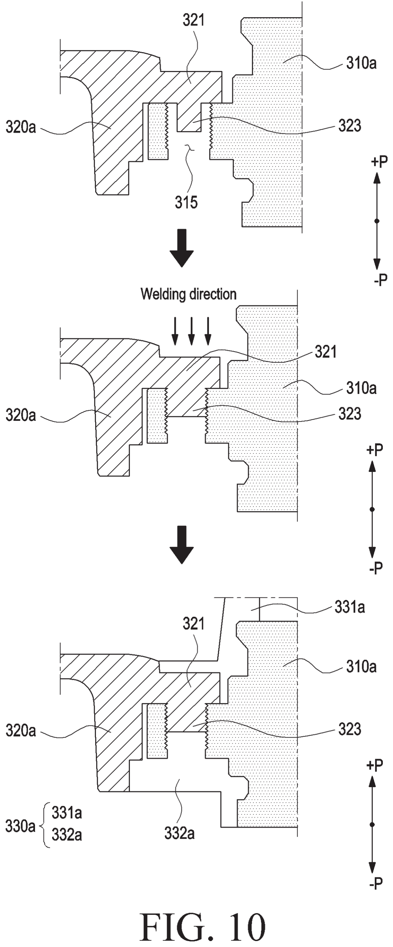

The configuration of the housing 201 in FIGS. 7 to 9 may be partially or entirely identical to the configuration of the housing 201 in FIGS. 4A and 4B. The embodiments of FIGS. 7 to 9 may be partially combined with the embodiments of FIGS. 1 to 4B, or with the embodiments of FIGS. 10 to 12C.

Hereinafter, before a final product is completed, such as before a bonding process (e.g., a welding process, a laser process, or a heating process) or before computer numerical control (CNC) processing, the first metal part 310 may be referred to as a first metal base material 310a, and the second metal part 320 may be referred to as a second metal base material 320a. A coupling portion 325 (e.g., the support portion 321 and the protruding portion 323) of the first metal part 310 may be referred to in the same manner. An opening 315 of the second metal part 320 may be referred to in the same manner. A molded portion 330 before computer numerical control (CNC) processing may be referred to as a molded base material 330a.

According to an embodiment, the process for forming the housing 201 may be performed by aligning portions of two metal base materials to be coupled, coupling a portion of one metal base material to the other metal base material through a bonding process (e.g., a welding process, a laser process, or a heating process), and then performing an injection-molding process on the coupled portions. Hereinafter, specific processes will be described.

First, a process for preparing two metal base materials (e.g., the first metal base material 310a and the second metal base material 320a) may be performed. The first metal base material 310a is the unprocessed form of a first metal part (e.g., the first metal part 310 in FIG. 5) for forming the exterior of the electronic device and may be defined as an outer metal base material. The second metal base material 320a may be the unprocessed form of a second metal part (e.g., the second metal part 320 in FIG. 5) disposed inside the first metal part (e.g., the first metal part 310 in FIG. 5) of the housing 201, and may be defined as an inner metal base material.

According to an embodiment, the first metal base material 310a and the second metal base material 320a may be formed of a single material. When the first metal base material 310a and the second metal base material 320a are formed of the single material, the single material may be at least one of steel use stainless (SUS), titanium (titan), magnesium, aluminum, ceramic, or glass.

According to an embodiment, the first metal base material 310a and the second metal base material 320a may be formed from different dissimilar metal materials. When formed from dissimilar metal materials, the first metal base material 310a may be at least one of steel use stainless (SUS), titanium (titan), or magnesium, while the second metal base material 320a may be a material that is easier to process than the first metal base material 310a, such as aluminum.

The prepared first metal base material 310a may undergo a processing process (e.g., process 10 in FIG. 7) to be coupled to the second metal base material 320a. The first metal base material 310a may be processed through a computer numerical control (CNC) process. In the CNC process, a portion of the first metal base material 310a may be processed to form an opening 315 for coupling with the second metal base material 320a.

According to an embodiment, the opening 315 of the first metal base material 310a may have a shape in which at least a partial space thereof expands in the -P direction. The -P direction may be the upward direction (e.g., the display direction) or the downward direction (e.g., the rear plate direction) of the electronic device 101. For example, the - P direction may be a direction (e.g., the -P direction) faced by a protruding portion 323 protruding from a support portion 321 of the second metal base material 320a (or the second metal part 320). For example, the -P direction may be a direction opposite to one surface (e.g., one surface facing the +P direction) of the support portion 321 of the second metal base material 320a (or the second metal part 320), on which a bonding process (e.g., a welding process or a laser process) is performed.

According to an embodiment, the opening 315 of the first metal base material 310a may be formed through one area of the first metal part 310. The opening 315 formed through one area of the first metal base material 310a may be formed such that the inner space thereof varies along the +P direction or the -P direction. For example, the inner space of the opening 315 of the first metal base material 310a may be sequentially (or progressively) expanded along the -P direction. For example, the opening 315 of the first metal base material 310a may have an undercut shape. For example, the inner surface of the first metal base material 310a forming the opening 315 may form an inclined surface having a specified inclination with respect to the upper surface (e.g., the surface facing +P) or the lower surface (e.g., the surface facing -P) of the first metal base material 310a adjacent to the opening 315. For example, the upper space (e.g., the space facing the -P direction) and the lower space (e.g., the space facing the +P direction) of the opening 315 of the first metal base material 310a may have different sizes.

The prepared second metal base material 320a may undergo a processing process (e.g., process 20) to be coupled to the opening 315 of the first metal base material 310a and the surrounding area thereof. The second metal base material 320a may be processed through a casting process. According to an embodiment, in the casting process, the second metal base material 320a may be processed to form a support portion 321 for coupling with the first metal base material 310a. According to an embodiment, in the casting process, the second metal base material 320a may be processed to form a support portion 321 for coupling with the first metal base material 310a and a protruding portion 323 extending from the support portion 321.

According to an embodiment, the support portion 321 of the second metal base material 320a may be in contact with the edge of the opening 315 of the first metal base material 310a and may be the portion on which a heating process (e.g., a welding process, a laser process, or a heating process) is performed. The protruding portion 323 of the second metal base material 320a may a portion to be inserted into the opening 315 of the first metal base material 310a, and may be formed to have a size smaller than the size (e.g., diameter) of the opening 315. The protruding portion 323 of the second metal base material 320a may have a pole shape, and may be formed such that when inserted into a portion of the opening 315, the protruding portion 323 is melted through a bonding process to come into contact with the inner surface of the opening 315.

Subsequently, an alignment process (e.g., process 30) for coupling the first metal base material 310a and the second metal base material 320a may be performed.

According to an embodiment, a plurality of coupling structures may be formed between the first metal base material 310a and the second metal base material 320a. The bonding structures may be formed in various ways within the area in which the first metal base material 310a and the second metal base material 320a come into contact.

According to an embodiment, when the second metal base material 320a includes the support portion 321 and the protruding portion 323, the support portion 321 of the second metal base material 320a may be disposed in contact with the adjacent edge of the opening 315 of the first metal base material 310a, and the protruding portion 323 of the second metal part 320 may be inserted into the opening of the first metal part 310.

According to an embodiment, when the second metal base material 320a includes only the support portion 321, the support portion 321 of the second metal base material 320a may be disposed in contact with the adjacent edge of the opening 315 of the first metal base material 310a.

Subsequently, a bonding process (e.g., process 40) for coupling the first metal base material 310a and the second metal base material 320a may be performed. A laser process or a welding process may be performed on a portion of the second metal base material 320a aligned with the first metal base material 310a.

According to an embodiment, in the case in which the second metal base material 320a includes the support portion 321 and the protruding portion 323, before the bonding process, the protruding portion 323 of the second metal base material 320a may be smaller than the inner space of the opening 315 of the first metal base material 310a, and thus may not be in a fitted and coupled state. When heat is applied to the upper surface (e.g., a surface facing +P) of the support portion 321 of the second metal base material 320a (e.g., the bonding process), the heat may be transferred to the support portion 321 and the protruding portion 323 protruding from the lower surface (e.g., a surface facing -P) of the support portion 321. A portion of the protruding portion 323 melted by the transferred heat may be deformed into a shape corresponding to the shape (e.g., an undercut shape) of the opening 315. After the bonding process is completed, the shape of the protruding portion 323 corresponding to the opening 315 may be an undercut shape and may be fitted in and coupled to the opening 315.

According to an embodiment of the disclosure, a process of performing heat treatment (e.g., a welding process or a laser process) toward the upper surface (e.g., one surface facing +P) of the support portion 321 of the second metal base material 320a may reduce the extent of processing of an outer metal (e.g., the first metal base material) compared to a process of performing heat treatment at the end of the protruding portion protruding into the opening (e.g., performing heat treatment from the opposite direction to the disclosure). Consequently, the overall processing time may be reduced. Furthermore, as the extent of processing of the outer metal (e.g., the first metal base material) is reduced, the rigidity of the entire housing may be increased.

According to an embodiment, the adjacent edge of the opening 315 of the first metal base material 310a and the support portion 321 of the second metal base material 320a may be partially melted to form a chemical coupling portion. The support portion 321 of the second metal base material 320a and/or the adjacent edge 401 (see FIG. 6) of the opening 315 melted together with the support portion 321 may be referred to as a melted portion. For example, the melted portion may include the support portion 321 and a portion of the protruding portion 323 adjacent to the support portion 321. For example, the melted portion may include the support portion 321, a portion of the protruding portion 323 adjacent to the support portion 321, and an inner portion of the opening 315 melted together with the portion of the protruding portion 323.

According to an embodiment, the protruding portion 323 of the second metal base material 320a inserted into the opening 315 of the first metal base material 310a may be fitted in and coupled to the opening 315 to form a physical coupling portion. In the bonding process (e.g., a welding process, a laser process, or a heating process), heat may be applied to the protruding portion 323 of the second metal base material 320a, and thus a portion of the protruding portion 323 may melt and fill a portion of the opening 315. Subsequently, the cooled protruding portion 323 may be fitted in and coupled to the opening 315 of the first metal base material 310a. A portion of the protruding portion 323 and/or the opening 315 which is fitted onto and coupled to the protruding portion 323 (e.g., the inner surface of the first metal base material 310a forming the opening 315) may be referred to as a non-melted portion. The protruding portion 323 of the second metal base material 320a may be provided to be inserted into only a portion of the opening 315 of the first metal part 310. After the bonding process (e.g., the welding process, the laser process, or the heating process), an increase in the melted and bonded areas of the first metal base material 310a and the second metal base material 320a may enhance the chemical coupling strength. An increase in the protruding portion 323 of the second metal base material 320a, which is filled into the expanded structural shape of the opening 315 without melting, may enhance the physical coupling strength by increasing the area in contact with the first metal base material 310a.

According to an embodiment, in the case in which the second metal base material 320a includes only the support portion 321, when heat is applied to the upper surface (e.g., a surface facing +P) of the support portion 321 of the second metal base material 320a (e.g., a bonding process), the heat may be transferred throughout the support portion 321. A portion of the support portion 321 that melts due to the transferred heat may flow into the opening 315 and fill a portion of the opening 315, thereby being deformed into a shape corresponding to the shape (e.g., the undercut shape) of a portion of the opening. After the bonding process (e.g., the welding process, the laser process, or the heating process) is completed, the modified portion of the support portion 321 protruding into the opening 315 may have an undercut shape and may be fitted in and coupled to the opening 315.

The following [Table 1] shows the bonding strength between the first metal base material 310a and the second metal base material 320a (or the second metal part 320), depending on the presence or absence of a protruding portion.

Table 1 shows a case in which a PUSH TEST was performed on the coupling structure between the first and second metal parts 310 and 320 after completion of the bonding process. When the bonding strength in the PUSH TEST is 10 kgf or greater, it was determined that the coupling structure can maintain high bonding strength without affecting the injection pressure provided during an injection-molding process.

**[Table 1]**

| PUSH TEST | | Bonding Strength (determining whether bonding strength is 10kgf or greater) | | | | |
|---|---|---|---|---|---|---|
| | Presence or absence of protruding portion | 1 | 2 | 3 | 4 | 5 |
| 1 | Absence of protruding portion | 38kgf | 41kgf | 35kgf | 38kgf | 40kgf |
| 2 | Presence of protruding portion | 44kgf | 48kgf | 43kgf | 44kgf | 47kgf |

Based on the presence or absence of a protruding portion of the second metal base material 320a (or the second metal part 320), five specimens were selected for each case. Subsequently, the bonding process was performed, followed by performing the PUSH TEST under identical conditions.

When the second metal base material 320a has no protruding portion, the results of the PUSH TEST for the bonding strength between the second metal base material 320a and the first metal base material 310a were found to be approximately 38 kgf, 41 kgf, 35 kgf, 38 kgf, and 40 kgf for the specimens.

When the second metal base material 320a has a protruding portion, the results of the PUSH TEST for the bonding strength between the second metal base material 320a and the first metal base material 310a were found to be approximately 44kgf, 48kgf, 43kgf, 44kgf, and 47kgf for the specimens.

In both the case in which the protruding portion of the second metal base material 320a is absent and the case in which the protruding portion is present, it can be observed that the test results for specimens that underwent the bonding process shows that all of the specimens are 10kgf or greater in PUSH TEST, and can maintain high bonding strength with the first metal base material to sufficiently withstand the injection pressure. Accordingly, it can be observed that the bonding structure between the first and second metal base materials according to the disclosure does not lose mechanical rigidity due to the injection pressure of a subsequent process (e.g., an injection-molding process) and the bonding surface can be consistently maintained.

When the second metal base material 320a has a protruding portion, higher PUSH TEST results can be observed compared to when the second metal base material 320a has no protruding portion. The protruding portion 323 of the second metal base material 320a provides a guide for alignment when directly inserted into the opening 315 of the first metal base material 310a before the bonding process, and after the bonding process is completed, may provide a stronger bonding structure with the first metal base material 310a.

After the bonding process, an injection-molding process (e.g., process 50) may be performed. The injection-molding process is performed by insert injection molding, which may form the high coupling strength between the first metal base material 310a and the second metal base material 320a, and may limit or reduce corrosion of the coupling structure formed between the first metal base material 310a and the second metal base material 320a.

According to an embodiment, a molded base material 330a formed by the injection-molding process may include a first molded base material portion 331a disposed on the upper side (e.g., the +P direction) of the coupling structure and a second molded base material portion 332a disposed on the lower side (e.g., the -P direction) of the bonding structure. The first molded portion 330 may be disposed to surround the upper surface (e.g., a surface facing the +P direction) of the support portion 321 of the second metal base material 320a and the first metal base material 310a in contact therewith. For example, the first molded base material portion 330a may be disposed to surround at least a portion of the melted portion (e.g., the support portion 321 of the second metal base material 320a and/or the adjacent edge 401 (see FIG. 6) of the opening 315 melted together with the support portion 321). The second molded base material portion 332a may be disposed to surround the outer surface (e.g., a surface facing the -P direction) of the protruding portion 323 of the second metal base material 320a and the first metal base material 310a in contact therewith. For example, the second molded base material portion 332a may be disposed within the opening 315 together with the protruding portion 323 of the second metal base material 320a. For example, the second molded base material portion 332a may be disposed to surround at least a portion of a non-melted portion (e.g., a portion of the protruding portion 323 of the second metal base material 320a and the inner surface of the first metal base material 310a forming the opening 315).

After the injection-molding process, the final form of the housing 201 may be designed by a computer numerical control (CNC) process (e.g., process 60).

FIG. 10 sequentially illustrates a coupling process among a first metal base material, a second metal base material, and a molded base material of a housing of an electronic device according to an embodiment of the disclosure.

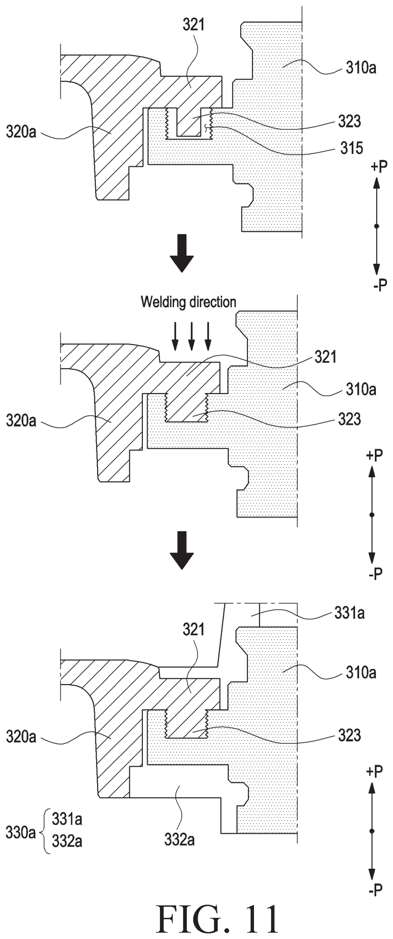

FIG. 11 sequentially illustrates a coupling process among a first metal base material, a second metal base material, and a molded base material of a housing of an electronic device according to an embodiment of the disclosure.

According to an embodiment, the electronic device 101 may include a housing 201 (e.g., the first support member 211 and the side structure 210 in FIGS. 4A and 4B). The housing 201 may include a first metal part (e.g., an outer metal part), a second metal part (e.g., an inner metal part), and a molded portion.

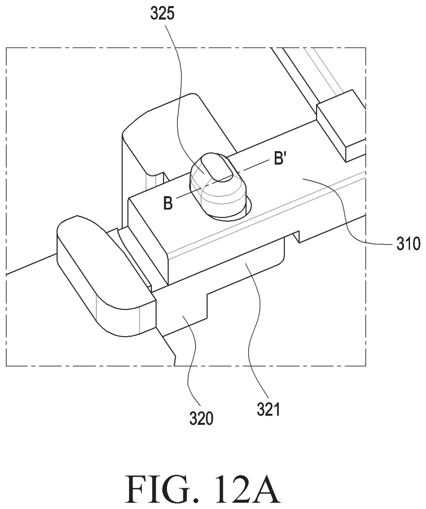

The configuration of the housing 201 in FIGS. 10 and 11 may be identical in part or in whole to the configuration of the housing 201 in FIGS. 4A and 4B. The embodiments of FIGS. 10 and 11 may be partially combined with the embodiments of FIGS. 1 to 9, or with the embodiments of FIGS. 12A to 12C.

Hereinafter, before a final product such as before a bonding process (e.g., a welding process, a laser process, or a heating process) or before computer numerical control (CNC) processing, the first metal part may be referred to as a first metal base material 310a, and the second metal part may be referred to as a second metal base material 320a. A coupling portion 325 (e.g., the support portion 321 and the protruding portion 323) of the first metal part may be referred to in the same manner. An opening 315 of the second metal part may be referred to in the same manner. A molded portion before computer numerical control (CNC) processing may be referred to as a molded base material 330a.

According to an embodiment, a process for forming the housing 201 may be performed by aligning portions of two metal base materials to be coupled, coupling a portion of one metal base material to the other metal base material through a bonding process (e.g., a welding process or a melting process), and then performing an injection-molding process on the coupled portions. Hereinafter, specific processes will be described.

First, a process for preparing two metal base materials (e.g., the first metal base material 310a and the second metal base material 320a) may be performed. According to an embodiment, the first metal base material 310a and the second metal base material 320a may be formed of a single material or dissimilar materials.

The prepared first metal base material 310a may undergo a processing process (e.g., process 10 in FIG. 7) to be coupled to the second metal base material 320a. The first metal base material 310a may be processed through a computer numerical control (CNC) process. In the CNC process, a portion of the first metal base material 310a may be processed to form the opening 315 for coupling with the second metal base material 320a.

According to an embodiment, the opening 315 of the first metal base material 310a may have a shape in which at least a partial space of the opening expands in a -P direction. The -P direction may be the upward direction (e.g., display direction) or the downward direction (e.g., rear plate direction) of the electronic device 101.

Referring to FIG. 10, the opening 315 of the first metal base material 310a may form a passage having a substantially constant diameter, and grooves or helical grooves may be formed at a specified interval (e.g., regular intervals) on the inner surface of the first metal base material 310a forming the opening 315. For example, screw tapping may be performed on the inner surface of the first metal base material 310a forming the opening 315.

Referring to FIG. 11, the opening 315 of the first metal base material 310a may be processed such that only one side thereof is open while the other side thereof is closed. For example, the opening 315 of the first metal base material 310a may be processed such that the upper space (e.g., the space facing the +P direction) is open, while the lower space (e.g., the space facing the -P direction) is closed. For example, the opening 315 of the first metal base material 310a may be a recess or groove shape.

The depth (e.g., the length in the -P direction or +P direction) of the opening 315 in FIG. 11 may be smaller than the depth (e.g., length in the -P direction or +P direction) of the opening 315 in FIG. 10. Grooves or helical grooves may be formed at a specified interval (e.g., regular intervals) on the inner surface of the first metal base material 310a forming the opening 315. For example, the inner surface of the first metal base material 310a forming the opening 315 may have grooves or helical grooves formed at a specified interval (e.g., regular intervals).

The prepared second metal base material 320a may undergo a processing process (e.g., process 20 in FIG. 7) to be coupled to an opening (e.g., the opening 315 in FIG. 10 or FIG. 11) of the first metal base material 310a and the surrounding area thereof. The second metal base material 320a may be processed through a casting process.

Subsequent processes (e.g., processes 30, 40, 50, and 60 in FIG. 7) may follow the housing formation process disclosed in FIGS. 7 to 9.

FIG. 12A illustrates the coupling relationship between a first metal part and a second metal part of a housing of an electronic device according to an embodiment of the disclosure.

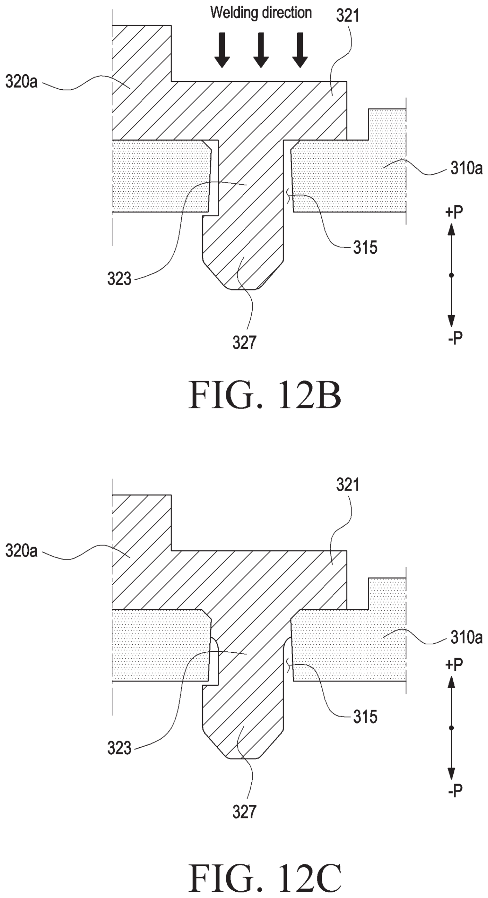

FIG. 12B illustrates the assembled state between a first metal base material and a second metal base material before a bonding process in a housing forming process for an electronic device according to an embodiment of the disclosure.

FIG. 12C illustrates the coupled state between a first metal base material and a second metal base material after a bonding process in a housing formation process for an electronic device according to an embodiment of the disclosure.

FIGS. 12B and 12C are cross-sectional views taken along line B-B' in FIG. 12A.

According to an embodiment, the electronic device 101 may include a housing 201 (e.g., the first support member 211 and the side structure 210 in FIGS. 4A and 4B). The housing 201 may include a first metal part (e.g., an outer metal part) and a second metal part (e.g., an inner metal part).

The configuration of the housing 201 in FIGS. 12A to 12C may be identical in part or in whole to the configuration of the housing 201 in FIGS. 4A and 4B. The embodiments in FIGS. 12A to 12C may be partially combined with the embodiments in FIGS. 1 to 10.

According to an embodiment, a process for forming the housing 201 may be performed by aligning portions of two metal base materials to be coupled, coupling a portion of one metal base material to the other metal base material through a bonding process (e.g., a welding process or a melting process), and then performing an injection-molding process on the coupled portions.

Hereinafter, before a final product such as before a bonding process (e.g., a welding process, a laser process, or a heating process) or before computer numerical control (CNC) processing, the first metal part may be referred to as a first metal base material 310a, and the second metal part may be referred to as a second metal base material 320a. A coupling portion 325 (e.g., the support portion 321 and the protruding portion 323) of the first metal part may be referred to in the same manner. An opening 315 of the second metal part may be referred to in the same manner.

First, a process for preparing two metal base materials (e.g., the first metal base material 310a and the second metal base material 320a) may be performed. According to an embodiment, the first metal base material 310a and the second metal base material 320a may be formed of a single material or dissimilar materials.

The prepared first metal base material 310a may undergo a processing process (e.g., process 10 in FIG. 7) to be coupled to the second metal base material 320a. The first metal base material 310a may be processed through a computer numerical control (CNC) process. In the CNC process, a portion of the first metal base material 310a may be processed to form the opening 315 for coupling with the second metal base material 320a.

According to an embodiment, the opening 315 of the first metal base material 310a may have a shape in which at least a partial space of the opening expands in a -P direction. For example, the -P direction may be the upward direction (e.g., display direction) or the downward direction (e.g., rear plate direction) of the electronic device 101. For example, the -P direction may be the direction (e.g., the -P direction) faced by the protruding portion 323 protruding from the support portion 321 of the second metal base material 320a. For example, the -P direction may be a direction opposite to one surface (e.g., a +P direction) of the support portion 321 of the second metal part 320, on which a process of applying heat (e.g., a welding process) is performed. According to an embodiment, the opening 315 of the first metal base material 310a (or the first metal part 310) may have a passage shape with a uniform diameter (or area).

The prepared second metal base material 320a may undergo a processing process (e.g., process 20 in FIG. 7) to be coupled to the opening (e.g., the opening 315 in FIG. 10 or FIG. 11) of the first metal base material 310a and the surrounding area thereof.

According to an embodiment, the second metal base material 320a may be at least partially surrounded by the first metal base material 310a and may include a coupling portion 325 for coupling with the opening 315 of the first metal base material 310a. The coupling portion 325 of the second metal base material 320a may include a support portion 321 adjacent to the edge of the upper space of the opening 315 of the first metal base material 310a, a protruding portion 323 extending from the support portion 321, and a hook portion 327 extending from the protruding portion 323 and adjacent to the edge of the lower space of the opening 315.

Subsequently, an alignment process (e.g., process 30) for coupling the first metal base material 310a and the second metal base material 320a, and a bonding process (e.g., process 40) for coupling the first metal base material 310a and the second metal base material 320a may be performed.

According to an embodiment, the support portion 321 of the second metal base material 320a may be disposed in contact with the upper surface (e.g., the surface facing the +P direction) of the first metal base material 310a and may face the upper space (e.g., the space facing the +P direction) of the opening 315. The protruding portion 323 of the second metal base material 320a may be formed to protrude from the support portion 321 in the -P direction and may be inserted into the opening 315 and coupled to a portion of the inner surface of the first metal base material 310a. The protruding portion 323 of the second metal base material 320a may have a pole shape and may be formed to come into contact with the inner surface of the opening 315 through a bonding process (e.g., a welding process, a laser process, or a heating process) while inserted into a portion of the opening 315.

According to an embodiment, the protruding portion 323 of the second metal base 320a may have a pole shape, and may be formed such that the upper portion of the protruding portion 323 comes into contact with the inner surface of the opening 315 through a bonding process (e.g., a melting process) while the protruding portion 323 is inserted to extend through the opening 315. At least a portion of the hook portion 327 of the second metal part 320 is disposed in contact with the lower surface (e.g., the surface facing the -P direction) of the first metal part 310 and may face the upper space (e.g., the space facing the +P direction) of the opening 315. The hook portion 327 of the second metal part 320 may partially protrude, together with the protruding portion 323, in a direction perpendicular to the +P direction, thereby preventing the second metal part 320 from being detached from the opening 315.

Referring to FIG. 12B, during the alignment process (e.g., process 30 in FIG. 7) for coupling the first metal base material 310a and the second metal base material 320a, the protruding portion 323 and the hook portion 327 of the second metal base material 320a may be inserted into the opening 315 of the first metal base material 310a so as to extend through the opening 315. Accordingly, in the aligned state of the first metal base material 310a and the second metal base material 320a, the protruding portion 323 of the second metal base material 320a may be positioned inside the opening 315 of the first metal base material 310a while forming a clearance space, and the support portion 321 of the second metal base material 320a may be disposed around the upper space of the opening 315 of the first metal base material 310a. The hook portion 327 of the second metal base material 320a may be disposed around the lower space of the opening 315 of the first metal base material 310a.

Referring to FIG. 12C, in a bonding process (e.g., process 40 in FIG. 7) for coupling the first metal base material 310a and the second metal base material 320a, a bonding process (e.g., a laser process or a welding process) may be performed on a portion of the second metal base material 320a aligned with the first metal base material 310a. Before the bonding process, the protruding portion 323 of the second metal base material 320a may be smaller than the inner space of the opening 315 of the first metal base material 310a, and thus may not be in a fitted and coupled state. When heat is applied to the upper surface (e.g., a surface facing the +P direction) of the support portion 321 of the second metal base material 320a (e.g., the bonding process), the heat may be transferred to the support portion 321 and a portion of the protruding portion 323 protruding from the lower surface (e.g., a surface facing the -P direction) of the support portion 321. The portion of the protruding portion 323, melted due to the transferred heat, may be deformed into a shape corresponding to the shape of the opening 315. For example, the upper portion of the protruding portion 323 may expand while being fitted in and coupled to the opening 315, whereas the lower portion of the protruding portion 323, which remains unmelted, may be smaller than the inner space of the opening 315 and thus may not be in a fitted and coupled state. After the bonding process (e.g., the laser process, the welding process, or the heating process) is completed, the shape of the protruding portion 323 corresponding to the opening 315 may be an undercut shape.

According to an embodiment, the bonding process may be performed in a state in which the second metal base material 320a has moved a predetermined distance in a direction perpendicular to the +P/-P direction. Accordingly, when viewed from below the first metal base material 310a (e.g., when viewed in the +P direction), the hook portion 327 of the second metal base material 320a may have a portion formed to overlap the first metal base material 310a, thereby limiting or reducing the detachment of the coupling portion 325 of the second metal base material 320a from the first metal base material 310a.

According to an embodiment, through the bonding process, the opening 315 of the first metal base material 310a, the surrounding area thereof, and the coupling portion 325 of the second metal base material 320a may include the melted portion 401 (see FIG. 6) and the non-melted portion 402 (see FIG. 6). The non-melted portion may be identified as a portion of the base material that melted and was fitted and coupled. The melted portion may provide chemical coupling between the first metal base material 310a and the second metal base material 320a, while the non-melted portion may provide physical coupling between the first metal base material 310a and the second metal base material 320a.

In a structure for coupling two metal parts to form a housing for an electronic device, a protruding portion of one metal part (e.g., an inner metal part) may be inserted to extend through an opening in the other metal part (e.g., an outer metal part), and then bonded by welding the area protruding from the opening. In this case, the end of the heated protruding area may be deformed into a dome shape. However, since heat is not transferred to one area of the inner metal part inserted into the opening, a space may be formed inside the coupling structure between the outer and inner metal parts. When the contact area between the outer and inner metal parts is insufficient, lifting and poor coupling between the outer and inner metal parts may occur due to injection pressure generated during a subsequent injection-molding process.

Furthermore, in the housing forming process, when the contact area between the outer metal part and the inner metal part is insufficient, voltage may not be adequately transferred from the inner metal part to the outer metal part during the surface treatment process, thereby causing uneven coloring during the surface treatment (e.g., anodizing).

Moreover, in the housing formation process, the metal parts of the housing in which the lifting has occurred may adversely affect antenna performance (e.g., VSWR performance).

According to various embodiments disclosed herein, in forming a housing for an electronic device, by varying the shape of an opening in an outer metal part and controlling the coupling direction of an inner metal part inserted into the opening and/or the direction in which a bonding process proceeds, stable bonding between the outer metal part and the inner metal part may be provided.

In the electronic device according to various embodiments, the coupling between the outer metal part and the inner metal part of the housing may include chemical coupling through a melted portion and physical bonding through a non-melted portion. Through the stable coupling between the outer metal part and the inner metal part, uneven coloring due to surface treatment may be reduced, and a structure favorable for antenna performance may be provided.

The housing of the electronic device according to various embodiments may provide strong coupling between the outer metal part and the inner metal part. For example, an outer metal structure having an opening (e.g., an undercut-shaped opening) in which a space expands may be assembled with an inner metal structure adjacent to the opening of the outer metal structure or inserted into the opening. After assembly, the inner metal part may undergo a bonding process (e.g., a welding process, a laser process, or a heating process), whereby a portion thereof is melted and another portion thereof is melted and strongly coupled to the opening of the outer metal part and the surrounding area of the opening.

In the housing formation process for the electronic device according to various embodiments, after the protruding portion of the inner metal part is inserted into the opening of the outer metal part and assembled, a bonding process (e.g., a welding process or a laser process) may be performed. During the bonding process, as heat is applied to a portion opposite to the end of the protruding portion, the inserted protruding portion may be entirely fitted in and coupled to the opening, thereby providing strong coupling with the outer metal part. Subsequently, in a processing process, as the processed area of the outer metal part is reduced, the area of the outer metal part within the housing may increase, thereby enhancing the housing's rigidity.

The effects obtainable from the disclosure are not limited to those mentioned above, and other effects not mentioned will be clearly understood by those skilled in the art to which the disclosure pertains from the following description.

An electronic device (e.g., the electronic device 101 in FIGS. 1 to 4) according to an embodiment of the disclosure may include a display 230 and a housing 201 in which the display is seated. The housing 201 may include a first metal part 310 at least partially exposed outside the electronic device, a second metal part 320 surrounded by the first metal part, and a molded portion 330. The first metal part may include an opening 315 formed through a portion of the first metal part, and the opening may be formed to have a space expanding in a first direction. The second metal part 320 may include a coupling portion 321 or 323 for coupling with the opening of the first metal part, and a portion of the coupling portion may form a melted portion. The molded portion 330 may cover the opening and at least a portion of the coupling portion.

According to an embodiment, a portion of the coupling portion of the second metal part 320 adjacent to the opening of the first metal part 310 may form a melted portion.

According to an embodiment, a portion of the coupling portion of the second metal part 320 inserted into the opening of the first metal part 310 may form a non-melted portion.

According to an embodiment, the first metal part 310 forming an area surrounding the upper space of the opening facing a second direction opposite to the first direction may form the melted portion.

According to an embodiment, a portion of the inner surface of the first metal part 310 forming the opening may form the non-melted portion.

According to an embodiment, the coupling portion of the second metal part 320 may include a support portion 321 disposed adjacent to the edge of the opening of the first metal part 310 and a protruding portion 323 extending from the support portion and inserted into the opening.

According to an embodiment, a portion of the support portion of the second metal part disposed in contact with the first metal part and a portion of the protruding portion adjacent to the support portion may form the melted portion.

According to an embodiment, the first direction in which the diameter of the opening expands may be the same as a direction faced by the protruding portion which protrudes from the support portion of the second metal part.

According to an embodiment, the diameter of the opening of the first metal part may gradually expand in the first direction.

According to an embodiment, the protruding portion of the second metal part may be formed to correspond to the shape of the opening, and thus coupled to the opening.

According to an embodiment, the height of the opening of the first metal part may be greater than the height of the protruding portion of the second metal part.

According to an embodiment, in the opening of the first metal part, the diameter of the lower space facing a direction opposite to the support portion of the second metal part may be larger than the diameter of the upper space facing the support portion of the second metal part.

According to an embodiment, the inner surface of the first metal part forming the opening may have a specified inclination with respect to one surface of the first metal part facing the support portion.

According to an embodiment, the support portion of the second metal part and the adjacent edge of the opening of the first metal part melted together with the support portion may provide chemical coupling.

According to an embodiment, the protruding portion of the second metal part inserted into the opening of the first metal part may provide physical coupling by being fitted in and coupled to the opening.

According to an embodiment, the molded portion 330 may include a first molded portion 331, disposed to surround the upper surface of the support portion of the second metal part facing a direction opposite to the first direction and the first metal part adjacent thereto, and a second molded portion 332, disposed to surround to surround the end of the protruding portion of the second metal part facing the first direction and the first metal part adjacent thereto.

According to an embodiment, the inner surface of the first metal part forming the opening may include grooves or helical grooves formed at specified intervals.

According to an embodiment, the opening of the first metal part may be open at the upper portion thereof to allow insertion of a portion of the second metal part, and closed at the lower portion thereof.

According to an embodiment, the coupling portion of the second metal part may further include a hook portion 327 extending from the protruding portion and adjacent to the edge of the lower space of the opening of the first metal part.

According to an embodiment, when viewed from below the first metal part, a portion of the hook portion of the second metal base material may overlap the first metal part.

A housing of an electronic device (e.g., the electronic device 101 in FIGS. 1 to 4) according to an embodiment of the disclosure may include a first metal part 310 at least partially exposed outside the electronic device, and a second metal part 320 surrounded by the first metal part. The first metal part may include an opening 315 formed through a portion of the first metal part and formed to have a space expanding in a first direction. The second metal part may include a coupling portion 325 for coupling with the opening of the first metal part, and a portion of the coupling portion may form a melted portion.

According to an embodiment, the coupling portion 325 of the second metal part may include a support portion 321 disposed adjacent to the edge of the opening of the first metal part 310 and a protruding portion 323 extending from the support portion and inserted into the opening.

According to an embodiment, a portion of the coupling portion 325 of the second metal part adjacent to the opening of the first metal part 310 may form a melted portion, and a portion of the coupling portion 325 of the second metal part inserted into the opening of the first metal part 310 may form a non-melted portion.

A method for manufacturing a housing for an electronic device according to an embodiment of the disclosure may include a process of processing a first metal base material including an opening formed to have a space expanding in a first direction, a process of processing a second metal base material including a coupling portion that is coupled to the opening of the first metal base, an alignment process for coupling the first metal base material and the second metal base material, wherein a support portion of the bonding portion being disposed in contact with the edge of the opening of the first metal base material, and a protruding portion extending from the support portion is disposed to be inserted into the opening of the first metal base material, a bonding process of applying heat to a surface of the support portion of the second metal base material aligned with the first metal base material, the surface of the support portion facing a second direction opposite to a first direction, and an injection-molding process of forming a molded base material portion in an area adjacent to the first metal base material and the second metal base material.

According to an embodiment, after the bonding process, the first metal base material forming an area surrounding the upper space of the opening facing the second direction opposite to the first direction may form a melted portion, and a portion of the inner surface of the first metal base material forming the opening may form a non-melted portion.

## Claims

1. An electronic device (101) comprising a housing (201),
wherein the housing (201) comprises:
a first metal part (310) at least partially exposed to an outside of the electronic device, and including an opening (315) formed to pass through a part of the first metal part, wherein the opening is formed to expand a space toward a first direction;
a second metal part (320) surrounded by the first metal part, and including a coupling portion (321, 323) for coupling to the opening of the first metal part, wherein a portion of the coupling portion is formed as a melted portion.

2. The electronic device of claim 1,
wherein a portion, adjacent to the opening of the first metal part (310), of the coupling portion of the second metal part (320) is formed as a melted portion, and
wherein a portion, inserted into the opening of the first metal part (310), of the coupling portion of the second metal part (320) is formed as a non-melted portion.

3. The electronic device of claim 1 or 2,
wherein the first metal part (310) forming a periphery around an upper space, facing a second direction opposite to the first direction, of the opening is formed as the melted portion, and
wherein a portion, forming the opening, of an inner surface of the first metal part (310) is formed as a non-melted portion.

4. The electronic device of any one of claims 1 to 3,
wherein the coupling portion of the second metal part (320) includes a support portion (321) disposed adjacent to an edge of the opening of the first metal part (310) and a protruding portion (323) extending from the support portion and inserted into the opening.

5. The electronic device of claim 4,
wherein a portion, disposed in contact with the first metal part, of the supporting portion of the second metal part and a portion of the protruding portion adjacent to the supporting portion are formed as a melted portion.

6. The electronic device of any one of claim 4 or 5,
wherein the first direction in which a diameter of the opening expands is the same as a direction in which the protruding portion protruding from the supporting portion of the second metal part points.

7. The electronic device of any one of claims 4 to 5,
wherein a diameter of the opening of the first metal part gradually expands along the first direction, and
wherein the protruding portion of the second metal part is formed to correspond to a shape of the opening and is coupled to the opening.

8. The electronic device of any one of claims 4 to 6,
wherein a height of the opening of the first metal part is greater than a height of a protruding portion of the second metal part.

9. The electronic device of any one of claims 4 to 6,
wherein, in the opening of the first metal part, a diameter of a lower space facing a direction opposite to the supporting portion of the second metal part is larger than a diameter of an upper space facing the supporting portion of the second metal part.

10. The electronic device of any one of claims 4 to 6,
wherein an inner surface of the first metal part forming the opening has a specified slope with respect to a surface where the first metal part faces the support portion.

11. The electronic device of any one of claims 4 to 10,
wherein the support portion of the second metal part and an adjacent edge of the opening of the first metal part melted together with the support portion provide a chemical bonding, and
wherein the protruding portion of the second metal part inserted into the opening of the first metal part is fitted into the opening to provide a physical bonding.

12. The electronic device of any one of claims 4 to 10, further comprising a molded portion 330 covering the opening and at least a portion of the coupling portion,
wherein the molded portion (330) comprises:
a first molded portion (331) disposed to surround an upper surface, facing an opposite direction of the first direction, of the support portion of the second metal part, and the first metal part adjacent thereto; and
a second molded portion (332) disposed to surround an end portion, facing the first direction, of the protruding portion of the second metal part and the first metal part adjacent thereto.

13. The electronic device of any one of claims 4 to 10,
wherein an inner surface of the first metal part forming the opening includes grooves formed at specified intervals or a spiral groove.

14. The electronic device of claim 13,
wherein the opening of the first metal part is configured such that an upper portion is open and a lower portion is closed to allow a portion of the second metal part to be inserted into the opening.

15. The electronic device of any one of claims 4 to 10,
wherein the coupling portion of the second metal part further includes a hook portion (327) extending from the protruding portion and adjacent to an edge of a lower space of the opening of the first metal part, and
wherein, when viewed from below the first metal part, a portion of the hook portion of the second metal base material overlaps the first metal part.
